# FASCICULE DE BREVET EUROPEEN

(11) **EP 0 401 071 B1**
(45) Date de publication et mention de la délivrance du brevet: **06.10.1993**
(21) Numéro de dépôt: 90401259.8
(22) Date de dépôt: 11.05.1990
(51) Int. Cl.: H01S 3/19

(54) **Laser semiconducteur à localisation de courant**
Halbleiterlaser mit Lokalisierung des Stroms
Localized-current semiconductor laser

(30) Priorité: 02.06.1989 FR 8907309
(43) Date de publication de la demande: 05.12.1990
(73) Titulaire: THOMSON HYBRIDES, 92800 Puteaux (FR)
(72) Inventeur: Tanguy, Christian, F-92045 Paris la Défense (FR); Marquebielle, Gérard, F-92045 Paris la Défense (FR); Mesquida, Guy, F-92045 Paris la Défense (FR)
(74) Mandataire: Taboureau, James

(56) Documents cités:
- EP-A- 0 273 730
- FR-A- 2 225 855
- PATENT ABSTRACTS OF JAPAN, vol. 7, no. 194 (E-195)[1339], 24 août 1983; & JP-A-58 96 791 (FUJITSU K.K.) 08-06-1983
- IEEE ELECTRON DEVICES LETTERS, vol. EDL-1, no. 5, mai 1980, pages 75-78, IEEE, New York, US; D. KASEMSET et al.: "Pb1-xSnxTe/PbTe1-ySey lattice-matched buried heterostructure lasers with CW single mode output"
- APPLIED PHYSICS LETTERS, vol. 40, no. 3, février 1982, pages 208-210, American Institute of Physics, New York, US; C.S. HONG et al.: "High-efficiency, low-threshold, Zn-diffused narrow stripe GaAs/GaAlAs double heterostructure lasers grown by metalorganic chemical vapor deposition"
- PATENT ABSTRACTS OF JAPAN, vol. 11, no. 61 (E-483)[2508], 25 février 1987; & JP-A-61 220 392 (TOSHIBA CORP.) 30-09-1986

## Description

La présente invention concerne un perfectionnement apporté à la structure d'un laser semiconducteur, de façon à améliorer la localisation du courant qui traverse le ruban émissif du laser.

On sait qu'un laser semiconducteur comporte au moins une couche dite active, émettrice de lumière, placée entre deux couches de confinement. Dans la couche active est défini, par gravure, un ruban : c'est lui qui, formant cavité de Fabry-Perot, émet un faisceau de lumière cohérente par ses deux faces clivées, aux extrémités du ruban.

Le courant injecté depuis une couche de contact, adjacente à une couche de confinement, vers le substrat, adjacent à une autre couche de confinement, crée l'émission de lumière par la couche active. L'un des problèmes des dispositifs semiconducteurs émetteurs de lumière est la localisation de l'injection de courant dans la seule région du ruban.

Une solution connue consiste à définir l'injection de courant dans la couche active au moyen d'une jonction polarisée en inverse, qui, s'étendant à l'entour du ruban actif, le circonscrit et s'oppose au passage du courant. Mais la réalisation d'une jonction, en cours de fabrication, necessite une épitaxie supplémentaire (croissance localisée) compliquant de façon notable de la réalisation.

Une autre solution simple connue consiste à réaliser deux diodes en parallèle, une homojonction et une hétérojonction, dont les différences de tension de coude permettent l'injection de courant de façon préférentielle dans la diode à plus petite tension du seuil. C'est donc la diode à hétérojonction, formée entre deux couches de confinement et la couche active, qui favorise le passage du courant à travers le ruban gravé. Ceci est valable pour un faible courant, mais, aux forts courants, le courant circulant dans la diode à homojonction n'est plus négligeable. De plus, l'efficacité du confinement du courant diminue lorsque la température augmente.

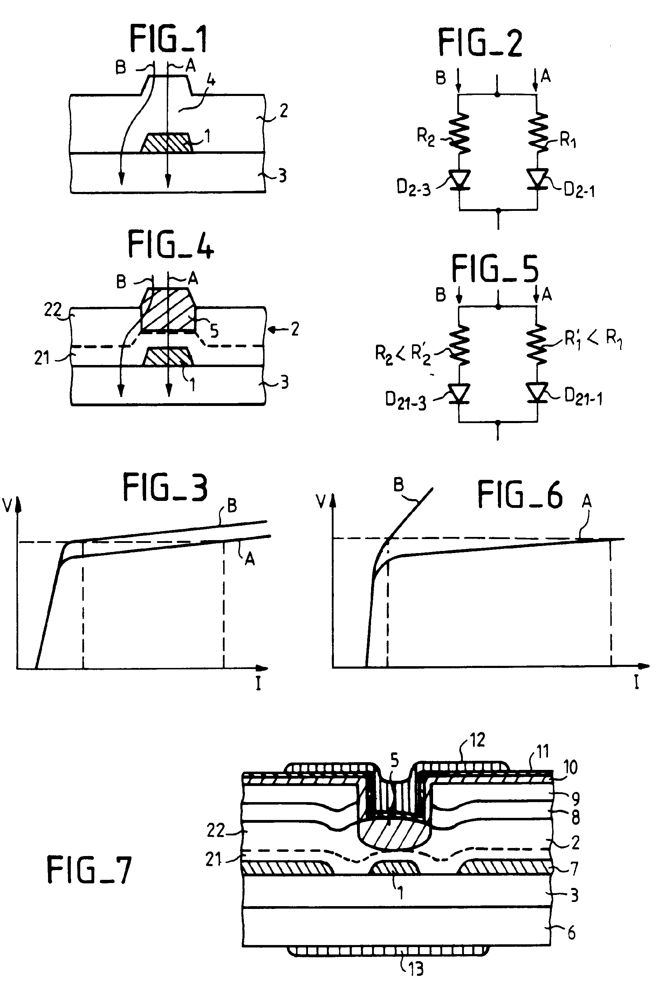

Ceci est illustré par les figures 1,2 et 3, relatives à l'art connu.

La figure 1 est volontairement limitée à la seule région d'un laser qui est nécessaire pour comprendre le fonctionnement : le substrat, les couches annexes, les métallisations de polarisation ne sont pas représentés.

Soit un ruban émissif 1 compris entre une première couche de confinement 2, en InP dopé de type P et une deuxième couche de confinement 3 en InP dopé de type N, par exemple. Dans ce cas, le ruban 1 est en GaInAsP, par exemple. La diode à faible tension de seuil est formée par l'hétérojonction 2-1-3 entre InP, GaInAsP et InP, et la diode à plus forte tension de seuil est formée par l'homojonction 2-3 entre InP de types P et N.

Le courant, qui traverse les couches, passe par la diode à hétérojonction -voie A- et par la diode à homojonction -voie B-. Le schéma électrique équivalent est donné en figure 2 : la résistance d'accès R₂ à la diode D₂₋₃ à homojonction est sensiblement la même que la résistance d'accès R₁ à la diode R₂₋₁ à hétérojonction. Seules diffèrent les tensions de coudes. Si l'on veut augmenter R₂ en dopant moins le matériau semiconducteur sur la voie B, on augmente également R₁ parce que le matériau semiconducteur est moins dopé en 4, sur la voie A d'accès au ruban 1, et on augmente le courant de fuite de l'homojonction.

Les courbes de V(I) pour ces deux diodes sont données en figure 3 : aux forts courants, le courant de fuite à travers la voie B est trop important par rapport au courant dans la voie A. Les deux courbes des deux diodes sont sensiblement parallèles.

L'invention apporte un perfectionnement à ce dispositif de localisation du courant injecté dans le ruban émissif, en créant un chemin préférentiel pour le courant, au moyen d'une diffusion localisée de zinc, à l'aplomb du ruban, dans une couche de matériau semiconducteur de confinement qui est elle-même à gradient de dopage, décroissant en s'éloignant du ruban émissif.

De façon plus précise, l'invention concerne un laser semiconducteur, comportant au moins un ruban émissif compris entre deux couches de confinement, et au moins une métallisation d'injection de courant, ce laser étant caractérisé en ce que la couche de confinement comprise entre le ruban émissif et la métallisation d'injection de courant est à gradient de dopage, décroissant en direction de la métallisation, et en ce qu'un puits obtenu par diffusion de zinc à travers ladite couche de confinement crée une localisation préférentielle du courant à travers le ruban émissif du laser.

L'invention sera mieux comprise par la description plus détaillée qui suit, en liaison avec les figures jointes en annexes, qui représentent :
- figures 1,2, et 3 : relatives à une diode laser selon l'art connu, elles ont été expliquées précédemment,
- figure 4 : coupe simplifiée du coeur d'un laser selon l'invention.
- figure 5 : schéma électrique équivalent d'un laser selon la figure 4
- figure 6 : courbe du courant de fuite latéral pour un laser selon la figure 4
- figure 7 : vue en coupe d'un laser selon l'invention.

De façon à faciliter la comparaison, la figure 4 ne reprend, à l'instar de la figure 1, que la partie de coeur du laser nécessaire pour les explications : un ruban émissif 1 compris entre deux couches de confinement 2 et 3.

Mais la première nouveauté, par rapport à la figure 1, est que la couche de confinement supérieure 2 comprise entre le ruban émissif 1 et le contact d'injection du courant, est à gradient de dopage, évoluant depuis un taux de 10¹⁸ at. cm⁻³ dans la région 21 voisine de l'homojonction 2/3, jusqu'à un taux de 2.10¹⁷ at.cm⁻³ dans la région 22 proche de l'interface 22/8. Cette couche de confinement a une épaisseur de l'ordre de 1,5 à 1,8µm, et elle est préférentiellement déposée par épitaxie par les organo-métalliques (MOCVD) ou par épitaxie par jets moléculaires (MBE), ces types d'épitaxie permettant la réalisation d'un gradient de dopage.

La seconde nouveauté, selon l'invention, réside en un puits d'accès 5, obtenu par diffusion localisée de zinc, à l'aplomb du ruban émissif 1 dans la couche active. Le dopage par le zinc est au niveau de 10¹⁸ at.cm⁻³. Cette diffusion descend jusqu'à contacter -ou tout au moins être extrêmement proche- la région 21 de la couche de confinement 2 qui surplombe le ruban émissif 1 : cette région 21 est dopée entre 2.10¹⁸ et 10¹⁸ at.cm⁻³. Il y a donc continuité de dopage à au moins 10¹⁸ at.cm⁻³ entre la métallisation de polarisation et le ruban émissif 1, créant ainsi un chemin préférentiel de localisation du courant dans le laser.

Le schéma électrique équivalent du laser selon l'invention, donné en figure 5, diffère du schéma d'un laser selon l'art connu en ce que :
- pour la voie A de localisation du courant, la résistance R'₁ (invention) est inférieure à la résistance R1 (art connu), en raison du puits dopé à au moins 10¹⁸ at.cm⁻³.
- pour la voie B du courant de fuite, la résistance R'₂ (invention) est supérieure à la résistance R₂ (art connu) parce que la couche d'accès en 22 est dopée graduellement entre 10¹⁸ at.cm⁻³ et 2.10¹⁷ at.cm⁻³ seulement, et parce que l'homojonction 21-3 présente une plus grande barrière de potentiel.

En outre, le surdopage dans la région 21 a comme effets, montrés en figure 6 :
- d'aplatir la pente de la courbe V(I) de la voie A, par rapport à la voie B
- de redresser la pente de la courbe V(I) de la voie B, de la diode à homojonction 21-3 par rapport à la voie A.

En conséquence pour la même valeur de la tension V pour obtenir un fort courant dans le laser (voie A), le courant de fuite est proportionnellement beaucoup plus faible (voie B), parce que les deux courbes ne sont plus quasi-parallèles, comme dans l'art connu.

La figure 7 donne une vue en coupe plus détaillée d'un laser selon l'invention. Il comporte, à titre d'exemple non limitatif :
- un substrat 6 en InP dopé N
- une deuxième couche de confinement 3, en InP dopé N
- une couche active 7 en GaInAsP, dans laquelle a été gravé un ruban émissif 1
- une première couche de confinement 2, en InP dopé P, de 1,5 à 1,8µm d'épaisseur, obtenue par épitaxie par MOCVD ou MBE. Sa région 21 en contact du ruban émissif 1 est dopée à 10¹⁸/7.10¹⁷ at.cm⁻³ et sa région 22 est dopée au niveau de 2 X 10¹⁷ at.cm⁻³.
- une couche ternaire 8, en GaInAs, de 0,1 µm, pour favoriser une attaque chimique différentielle (faiblement dopée p 2.10¹⁷ at. cm⁻³)
- une couche de bloquage 9, en InP dopé N.

Cette structure est partiellement gravée, à l'aplomb du ruban émissif 1, pour atteindre la couche de contact 8 et, après les masquages nécessaires, un puits 5 est diffusé, par dopage au zinc, au niveau de 10¹⁸ at.cm⁻³. Le puits 5 est suffisamment profond pour entrer en contact avec la région surdopée 21 à l'aplomb du ruban émissif 1. Au cours de la diffusion de zinc, la région superficielle 10 de la couche bloquante 9 est également diffusée.

Le laser est complété par une métallisation 11 de Pt/Au, pour le contact P, d'injection de courant, renforcé par une recharge 12 d'or électrolytique, et, sous le substrat 6, par une métallisatlon 13 de Au-Mo-Au pour le contact N.

Il est évident que la structure détaillée et les matériaux des couches peuvent être différents de ceux qui ont été choisis pour exposer l'invention, sans sortir du cadre défini par les revendications qui suivent.

Ce type de laser est utilisé en télécommunications ou traitement de données par fibres optiques.

## Revendications

1. Laser semiconducteur, comportant au moins un ruban émissif (1) compris entre deux couches de confinement (2,3), et au moins une métallisation (11,12) d'injection de courant, ce laser étant caractérisé en ce que la couche de confinement (2) comprise entre le ruban émissif (1) et la métallisation (11,12) d'injection de courant est à gradient de dopage, décroissant en direction de la métallisation, et en ce qu'un puits (5) obtenu par diffusion de zinc à travers ladite couche de confinement (2) crée une localisation préférentielle du courant à travers le ruban émissif (1) du laser.

2. Laser semiconducteur selon la revendication 1, caractérisé en ce que le dopage de la couche de confinement (2) décroît de 10¹⁸ at.cm⁻ ³ dans la région (21) proche du ruban émissif (1) , à 2.10¹⁷at.cm⁻³ dans la région (22) proche de la métallisation d'injection de courant (11,12);

3. Laser semiconducteur selon la revendication 1, caractérisé en ce que le puits (5) qui traverse la couche de confinement (2) est dopé au niveau de 10¹⁸ at.cm⁻³.

4. Laser semiconducteur selon la revendication 2, caractérisé en ce que le puits diffusé (5) dans la couche de confinement (2) est en contact avec la région surdopée (21) de ladite couche (2), établissant une continuité électrique entre la metallisation (11,12) d'injection de courant et le ruban émissif (1).

## Patentansprüche

1. Halbleiterlaser mit mindestens einem Emissionsband (1), das zwischen zwei Einschließungsschichten (2, 3) liegt, und mit mindestens einem Metallbelag (11, 12) zur Stromeinspeisung, dadurch gekennzeichnet, daß die Einschließungsschicht (2), die sich zwischen dem Emissionsband (1) und dem Metallbelag (11, 12) zur Stromeinspeisung befindet, einen Dotierungsgradienten besitzt, wobei die Dotierung zum Metallbelag hin abnimmt, und daß ein durch Zinkdiffusion durch die Einschließungsschicht (2) erhaltener Topf (5) eine bevorzugte Lokalisierung des Stroms durch das Emissionsband (1) des Lasers erzeugt.

2. Halbleiterlaser nach Anspruch 1, dadurch gekennzeichnet, daß die Dotierung der Einschließungsschicht (2) von 10¹⁸ Verunreinigungen cm⁻³ in der Zone (21) in der Nähe des Emissionsbandes (1) auf 2.10¹⁷ Verunreinigungen cm⁻³ in der Zone (22) in der Nähe des Metallbelags zur Stromeinspeisung (11, 12) abnimmt.

3. Halbleiterlaser nach Anspruch 1, dadurch gekennzeichnet, daß der Topf (5), der die Einschließungsschicht (2) durchquert, mit 10¹⁸ Verunreinigungen cm⁻³ dotiert ist.

4. Halbleiterlaser nach Anspruch 2, dadurch gekennzeichnet, daß der in die Einschließungsschicht (2) eindiffundierte Topf (5) mit der überdotierten Zone (21) dieser Schicht (2) in Kontakt steht und so eine elektrische Kontinuität zwischen dem Metallbelag (11, 12) zur Stromeinspeisung und dem Emissionsband (1) herstellt.

## Claims

1. Semiconductor laser, comprising at least one emission stripe (1) contained between two confinement layers (2,3), and at least one current-injection metallisation (11,12), this laser being characterised in that the confinement layer (2) contained between the emission stripe (1) and the current-injection metallisation (11, 12) has a doping gradient, decreasing in the direction of the metallisation, and in that a well (5) obtained by diffusion of zinc through the said confinement layer (2) creates a preferential localisation of the current through the emission stripe (1) of the laser.

2. Semiconductor laser according to Claim 1, characterised in that the doping of the confinement layer (2) decreases from 10¹⁸ at.cm⁻³ in the region (21) close to the emission stripe (1), to 2.10¹⁷ at.cm⁻³ in the region (22) close to the current-injection metallisation (11,12);

3. Semiconductor laser according to Claim 1, characterised in that the well (5) which passes through the confinement layer (2) is doped at the level of 10¹⁸ at.cm⁻³.

4. Semiconductor laser according to Claim 2, characterised in that the well (5) diffused in the confinement layer (2) is in contact with the very heavily doped region (21) of the said layer (2), establishing electrical continuity between the current-injection metallisation (11,12) and the emission stripe (1).
